# EUROPEAN PATENT APPLICATION

(11) **EP 4 257 632 A1**
(43) Date of publication of application: **11.10.2023**
(21) Application number: 22756530.6
(22) Date of filing: 17.02.2022
(51) Int. Cl.: C08G 77/04, C08G 77/30, C08L 83/06, C09D 183/06, G03F 7/075

(54) **PHOTOSENSITIVE COMPOSITION COMPRISING ORGANIC METAL COMPOUND AND POLYSILOXANE COPOLYMER, AND PREPARATION METHOD THEREFOR**

(30) Priority: 18.02.2021 KR 20210021710
(71) Applicant: Hunet Plus Co., Ltd., Cheonan-si, Chungcheongnam-do 31075 (KR)
(72) Inventor: CHA, Hyuk Jin, Seoul 06191 (KR); LEE, Eung Chan, Gunpo-si Gyeonggi-do 15821 (KR); KIM, Keun Soo, Daejeon 35244 (KR)
(74) Representative: Prüfer & Partner mbB Patentanwälte · Rechtsanwälte
(86) International application number: PCT/KR2022/002381
(87) International publication number: WO 2022/177332

(57) **Abstract**

The present invention provides a photosensitive composition comprising a copolymer of an organometallic compound and polysiloxane that may be used in a photosensitive material for a display or semiconductor, and a method for preparing the same.

## Description

### [Technical Field]

The present invention relates to a photosensitive composition comprising an organometallic compound and a polysiloxane copolymer and a method for preparing the same, and more specifically, to a photosensitive composition comprising a copolymer of an organometallic compound and polysiloxane that may be used in a photosensitive material for a display or semiconductor, and a method for preparing the same.

### [Background Art]

In recent years, various proposals have been made to improve the efficiency of use of new light and to save energy, in optical elements, such as a display, a light emitting diode, and a solar cell. For example, in a liquid crystal display, there is known a method of increasing an aperture ratio of a display device by coating and forming a transparent flattening film on a TFT element and forming a pixel electrode on the flattening film. In addition, there is proposed a method of improving an aperture ratio similarly to a liquid crystal display by making the constitution of the organic EL device, from a method of depositing a light emitting layer on a transparent pixel electrode formed on a substrate and taking out light emission from the substrate side (bottom emission), to a method of forming a transparent pixel electrode on a flattening film coated on a TFT element, forming a light emitting layer thereon, and taking out light emission from the side opposite to the TFT element (top emission).

In addition, with higher resolution/larger size, higher image quality/3D display, and the like of the display, signal delay on wiring becomes a problem. Although the input signal to the TFT has been shortened due to the speeding up of the image information rewriting speed (frame frequency), there is a limit to the extension of the wiring width to lower the wiring resistance due to the demand for higher resolution. For this reason, it has been proposed to solve the problem of signal delay by increasing the wiring thickness.

As a material for such a flattening film for TFT substrates, a combined material of an acrylate resin and a quinonediazide compound is known. However, these materials do not rapidly deteriorate material properties at high temperatures of 200°C or higher, but have a problem that decomposition starts gradually at 230°C or higher and the transparent film is colored due to a decrease in the film thickness or a high-temperature treatment of the substrate, resulting in a decrease in transmittance. In particular, it cannot be used in a process for forming a film on the transparent film material at a high temperature using an apparatus such as PE-CVD. In addition, since the decomposition product adversely affects the luminous efficiency and lifetime of organic EL device also in organic EL device, acrylic material cannot be said to be an optimal material for use in high-temperature processes or devices affected by impurities. In addition, an acrylic material to which heat resistance is imparted generally has a high dielectric constant. For this reason, as the parasitic capacitance of the insulating film increases, power consumption increases, or the liquid crystal element driving signal is delayed, or the like, which causes problems in the quality of image quality. Even in an insulating material with a large dielectric constant, for example, the capacitance may be reduced by increasing the film thickness, but it is generally difficult to form a uniform coating film with a film thickness of, for example, 5 microns or more by a slit coating method or the like on a large glass substrate, and it is not preferable to increase the film thickness because the amount of material used also increases.

Polysiloxane is known as a material with high heat resistance and high transparency. Polysiloxane is a polymer consisting of trifunctional siloxane structural unit (RSiO_{1.5}), and is a chemical structure intermediate between inorganic silica (SiO₂) and organic silicon (R₂SiO), but is a specific compound that is soluble in organic solvents and exhibits high heat resistance characteristic of inorganic silica as a cured product. In addition, the polymer having a siloxane skeleton generally has a lower dielectric constant compared with an organic polymer and is expected as a material for a low dielectric transparent insulating film.

On the other hand, in the manufacture of optical devices such as organic EL (electro-luminescence) devices, quantum dot displays, TFT (thin film transistor) arrays, and thin film solar cells, as one of the methods of implementing a pattern, an inkjet (IJ) method of forming an organic layer, such as a light emitting layer, with dots using an inkjet head has been used.

The inkjet (IJ) method has advantages such as that since it is a printing method that does not use a substrate, the cost for manufacturing the substrate may be reduced, and since the material is used only in the required amount for the necessary part, the material cost may be reduced.

In this inkjet method, dots of a desired pattern are formed by injecting an ink containing an organic layer material into a compartment (hereinafter, also referred to as an "aperture") surrounded by partition walls, and drying and/or heating the ink.

When printing a pattern by the inkjet method, in order to prevent the mixing of ink between adjacent dots and uniformly apply the ink in the dot formation, the upper surface of the partition walls formed along the outline of the dot needs to have ink repellency. For this purpose, the partition walls corresponding to the pattern of the dots are formed by the photolithography method using the photosensitive resin composition containing the ink repellent agent.

In addition, polysiloxane has excellent heat resistance, transparency, chemical stability, and the like, and thus is applied to printed circuit board materials, window cover film materials, photosensitive materials, and the like. In particular, polysiloxane as a photosensitive material exhibits excellent physical properties in flexibility, transparency, photosensitivity, durability, and the like. However, since a high taper angle and a steep inclination angle appear with respect to the substrate surface when forming a pattern with the coating solution containing such polysiloxane, it is difficult to implement the low taper angle and the gentle round inclination angle required for partition wall materials (pixel define layer) and the like of OLED materials. In addition, there is a limitation in applying it to a process that requires a different height when forming a pattern such as a black column spacer.

### [Prior Art Documents]

### [Patent Documents]

(Patent Document 0001) Korean Patent No. 10-0143859
(Patent Document 0002) Korean Patent No. 10-0655945

### [Disclosure]

### [Technical Problem]

In order to solve the above-mentioned problems, the present invention provides a photosensitive composition comprising a copolymer of an organometallic compound and polysiloxane that may be used in a photosensitive material for a display or semiconductor, and a method for preparing the same.

### [Technical Solution]

In order to solve the above-mentioned problems, the present invention provides a photosensitive composition comprising a copolymer having a structure of following Formula 1: 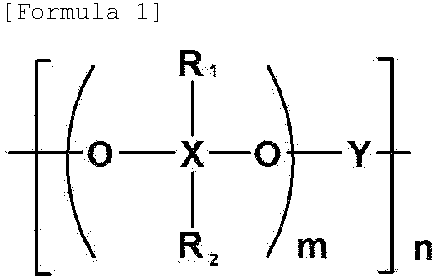 wherein: R₁ and R₂ are each a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, a hydroxyl group (-OH), or an ether group (-O-); X is silicon (Si), titanium (Ti), germanium (Ge), zirconium (Zr), tin (Sn), lead (Pb), bismuth (Bi), antimony (Sb), tellurium (Te), hafnium (Hf), indium (In), or aluminum (Al); Y is a carbonyl group (-COO-), a sulfonyl group (-SO₂-), a phosphoryl group (-PO₃-), or an ether group bonded to a neighboring silanol; m is an integer from 1 to 100; and n is an integer from 1 to 100.

In one embodiment, the copolymer may include a structure of following Formula 2 and a structure of following Formula 3: 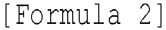 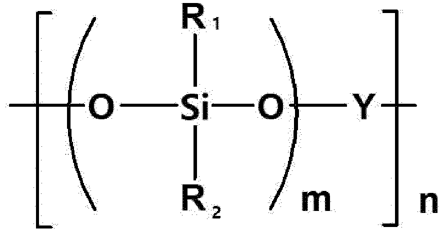
wherein: R₁ and R₂ are each a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, a hydroxyl group (-OH), or an ether group (-O-); Y is a carbonyl group (-COO-), a sulfonyl group (-SO₂-), a phosphoryl group (-PO₃-), or an ether group bonded to a neighboring silanol; m is an integer from 1 to 100; and n is an integer from 1 to 100. 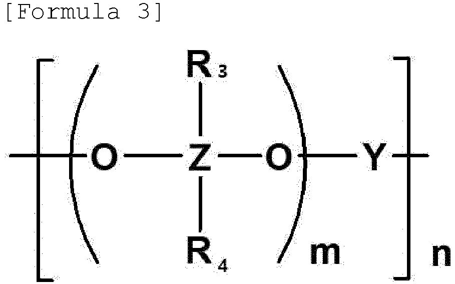
wherein: R₃ and R₄ are each a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, a hydroxyl group (-OH), or an ether group (-O-); Z is titanium (Ti), germanium (Ge), zirconium (Zr), tin (Sn), lead (Pb), bismuth (Bi), antimony (Sb), tellurium (Te), hafnium (Hf), indium (In), or aluminum (Al); Y is a carbonyl group (-COO-), a sulfonyl group (-SO₂-), a phosphoryl group (-PO₃-), or an ether group bonded to a neighboring silanol; m is an integer from 1 to 100; and n is an integer from 1 to 100.

In one embodiment, the copolymer may include a structure of following Formula 4 or 5: 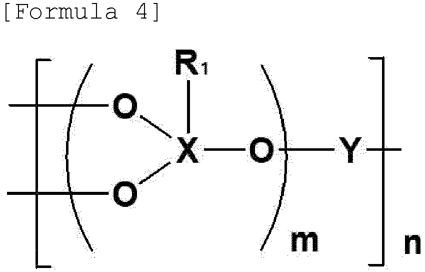
wherein: R₁ is a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, or a hydroxyl group (-OH); X is silicon (Si), titanium (Ti), germanium (Ge), zirconium (Zr), tin (Sn), lead (Pb), bismuth (Bi), antimony (Sb), tellurium (Te), hafnium (Hf), indium (In), or aluminum (Al); Y is a carbonyl group (-COO-), a sulfonyl group (-SO₂-), a phosphoryl group (-PO₃-), or an ether group bonded to a neighboring silanol; m is an integer from 1 to 100; and n is an integer from 1 to 100. 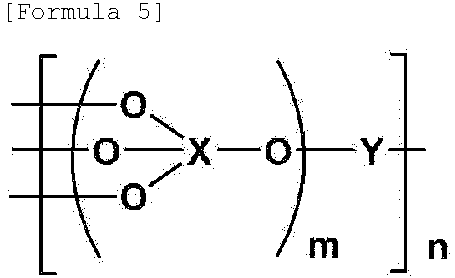
wherein: X is silicon (Si), titanium (Ti), germanium (Ge), zirconium (Zr), tin (Sn), lead (Pb), bismuth (Bi), antimony (Sb), tellurium (Te), hafnium (Hf), indium (In), or aluminum (Al); Y is a carbonyl group (-COO-), a sulfonyl group (-SO₂-), a phosphoryl group (-PO₃-), or an ether group bonded to a neighboring silanol; m is an integer from 1 to 100; and n is an integer from 1 to 100.

In one embodiment, the copolymer may include a structure of following Formula 6: 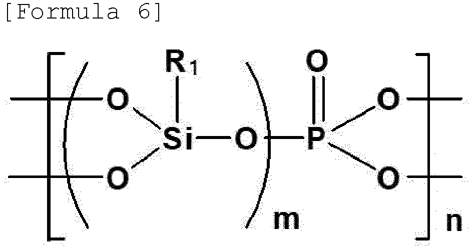 wherein: R₁ is a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, a hydroxyl group (-OH), or an ether group (-O-); m is an integer from 1 to 100; and n is an integer from 1 to 100.

In one embodiment, the weight ratio of Formula 2 and Formula 3 may be 1:9 to 9.9:0.1.

In one embodiment, the photosensitive composition may further comprise 1 to 10 parts by weight of a photosensitizer, 30 to 50 parts by weight of a solvent, 0.1 to 1 parts by weight of an adhesion aid, and 0.1 to 1 parts by weight of a surfactant relative to 100 parts by weight of the copolymer.

The present invention also provides a method for preparing the photosensitive composition, comprising the steps of:
adding and mixing a monomer having a structure of following Formula 7 to a polymerization solvent to produce a monomer mixture: 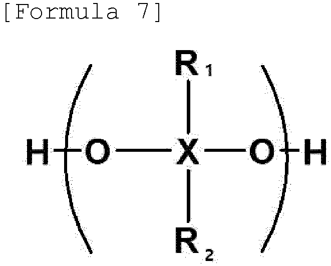
wherein: R₁ and R₂ are each a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, a hydroxyl group (-OH), or an ether group (-O-); and X is silicon (Si), titanium (Ti), germanium (Ge), zirconium (Zr), tin (Sn), lead (Pb), bismuth (Bi), antimony (Sb), tellurium (Te), hafnium (Hf), indium (In), or aluminum (Al);
mixing a copolymerization monomer with the monomer mixture, and then adding an acid catalyst dropwise to produce a copolymer; and mixing 1 to 10 parts by weight of a photosensitizer, 30 to 50 parts by weight of a solvent, 0.1 to 1 parts by weight of an adhesion aid and 0.1 to 1 parts by weight of a surfactant relative to 100 parts by weight of the copolymer to produce the photosensitive composition, wherein the copolymerization monomer is a compound containing a carbonyl group, a sulfonyl group, or a phosphoryl group, and wherein the acid catalyst is one or more selected from oxalic acid, hydrofluoric acid, hydrochloric acid, hydrobromic acid, sulfuric acid, nitric acid, perchloric acid, phosphoric acid, methanesulfonic acid, benzenesulfonic acid, and toluenesulfonic acid.

In one embodiment, the monomer having the structure of Formula 7 is in admixture of two or more kinds of monomers.

### [Advantageous Effects]

The photosensitive composition comprising the organometallic compound and the polysiloxane copolymer according to the present invention and a method for preparing the same have excellent heat resistance, flexibility and transparency, and excellent storage stability, and in particular, may control the pattern shape according to the content of the non-silane-based copolymer monomer. Specifically, it is possible to control the taper angle according to the content of the non-silane-based copolymer monomer, and implement a pattern representing a shape such as a straight line type (vertical straight type) or a lying type (gentle round shape), while the polysiloxane copolymer according to the present invention has silane-based functional groups as a basic structure.

In addition, in the case of the present invention, as a polysiloxane copolymer includes an organometallic compound having a structure similar to the polysiloxane copolymer, it is possible to implement high sensitivity and high resolution equivalent to or higher than that of existing polysiloxane-based polymers while having excellent heat resistance and chemical resistance. Thus, it may be usefully used not only in materials used for displays such as OLED or QLED, but also in semiconductor manufacturing fields such as EUV semiconductors.

### [Description of Drawings]

Figure 1 is a SEM photograph of a pattern made of a photosensitive composition according to one embodiment of the present invention.
Figure 2 is a SEM photograph of a pattern made of a photosensitive composition according to one embodiment of the present invention.
Figure 3 is a SEM photograph of a pattern made of a photosensitive composition according to one embodiment of the present invention.
Figure 4 is a SEM photograph of a pattern made of a photosensitive composition according to one embodiment of the present invention.
Figure 5 is a graph of 1H-NMR analysis results according to one embodiment of the present invention.
Figure 6 is a graph of FR-IR analysis results according to one embodiment of the present invention.

### [Best Mode]

Hereinafter, preferred embodiments of the present invention will be described in detail. In describing the present invention, if it is judged that the specific description of the related known technologies may obscure the gist of the present invention, the detailed description thereof will be omitted. Throughout the specification, the singular expression is to be understood as including the plural expression unless the context clearly dictates otherwise, and terms such as "comprise," "have," and the like are intended to indicate that there is a feature, number, step, operation, element, part, or combination thereof described, and it should be understood that the terms do not exclude in advance the possibility of the presence or addition of one or more other features, numbers, steps, operations, elements, parts, or combinations thereof. In addition, in performing the method or the manufacturing method, each process constituting the method may occur differently from the specified order unless a specific order is clearly described in context. That is, each process may occur in the same order as specified, may be performed substantially simultaneously, or may be performed in the reverse order.

Since various modifications may be made to the present invention and the present invention may have various embodiments, specific embodiments will be illustrated and described in detail in the detailed description. However, this not intended to limit the present invention to specific embodiments, it is to be understood that this includes all modifications, equivalents, and substitutes included in the spirit and technical scope of the present invention.

The technology disclosed in the present specification is not limited to the embodiments described herein and may be embodied in other forms. However, the embodiments introduced herein are provided so that the disclosed content may be thorough and complete, and the technical spirit of the present technology may be sufficiently conveyed to those skilled in the art. In order to clearly express the elements of each device in the drawings, the dimensions of width, thickness, and the like of the elements are somewhat enlarged. In the description of the drawings, it was described from the viewpoint of the observer on the whole, and when an element is referred to as being positioned on another element, this includes both the meaning that an element may be positioned directly on another element, or an additional element may be interposed between the elements. In addition, a person having ordinary skill in the art will be able to implement the spirit of the present invention in various other forms within the scope without departing from the technical spirit of the present invention. In addition, the same reference numerals in the plurality of drawings refer to elements that are substantially the same as each other.

In this specification, the term "and/or" includes a combination of a plurality of listed items, or any of a plurality of listed items. In this specification, "A or B" may include "A," "B," or "both A and B."

The present invention relates to a photosensitive composition comprising a copolymer having a structure of following Formula 1: 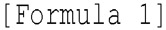 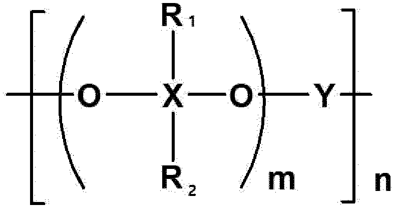 wherein: R₁ and R₂ are each a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, a hydroxyl group (-OH), or an ether group (-O-); X is silicon (Si), titanium (Ti), germanium (Ge), zirconium (Zr), tin (Sn), lead (Pb), bismuth (Bi), antimony (Sb), tellurium (Te), hafnium (Hf), indium (In), or aluminum (Al); Y is a carbonyl group (-COO-), a sulfonyl group (-SO₂-), a phosphoryl group (-PO₃-), or an ether group bonded to a neighboring silanol; m is an integer from 1 to 100; and n is an integer from 1 to 100.

The copolymer of Formula 1 of the present invention may be composed of a siloxane-based compound or an organometallic compound having a structure similar to the siloxane-based compound and a non-silane-based monomer represented by Y. In this case, when X in Formula 1 is silicon (Si), Formula 1 may be composed of a polysiloxane-based copolymer, and when X is a metal atom, it may be composed of an organic compound-based copolymer.

In the case of the existing siloxane-based polymer, since only siloxane is used for the main skeleton of the polymer, a high taper angle and a steep inclination angle appear with respect to the substrate surface when forming a pattern with the coating solution containing such polysiloxane, and thus, it is difficult to implement the low taper angle and the gentle round inclination angle required for partition wall materials (pixel define layer) and the like of OLED materials. In addition, there is a limitation in applying it to a process that requires a different height when forming a pattern such as a black column spacer.

However, in the case of the present invention, the siloxane-based compound or an organometallic compound having a structure similar to the siloxane-based compound and a non-silane-based monomer are copolymerized, and in this case, a pattern shape may be controlled according to the ratio of the non-silane-based monomer. Specifically, it is possible to control the taper angle according to the content of the non-silane-based copolymer monomer, and implement a pattern representing a shape such as a straight line type (vertical straight type) or a lying type (gentle round shape), while the copolymer according to the present invention has a siloxane-based compound or an organometallic compound functional groups having a structure similar to the siloxane-based compound as a basic structure.

In this case, when m is 1, the siloxane-based compound or the organometallic compound having a structure similar to the siloxane-based compound and the non-silane-based monomer are copolymerized in a 1:1 ratio to have a low taper angle with respect to the substrate surface, and thus, when implementing the pattern, it is possible to implement a pattern in the form of lying close to the horizontal. As m increases, the proportion of the siloxane-based compound or the organometallic compound having a structure similar to the siloxane-based compound in the copolymer increases, and in this case, the taper angle may be increased to control the inclination angle of the pattern. In addition, when m is 100, since there is almost no effect due to the non-silane-based monomer, it is possible to implement a straight line type pattern close to vertical. Thus, m may be an integer from 1 to 100. When m is less than 1, it may be difficult to form a copolymer, and when it is more than 100, the effect of the non-silane-based compound does not appear, and thus, there may be no difference from the existing polysiloxane.

R₂ and R₂ above refer to a functional group bonded to silicon (Si) or a metal atom, which is a central atom in the siloxane-based compound or an organometallic compound having a structure similar to the siloxane-based compound, and may be specifically a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, a hydroxyl group (-OH), or an ether group (-O-).

In particular, when R₁ and R₂ are hydroxyl groups, they may bond to an adjacent siloxane-based compound or an organometallic compound having a structure similar to the siloxane-based compound. In this case, the hydroxyl group may be condensed by dehydration to form an ether group. The formation of such an ether group may occur in both R₁ and R₂, but may only occur in any one of R₁ and R₂. In addition, the ether group may be derived from a hydroxyl group as described above, but may also be formed by a condensation reaction of other hydrocarbons or hydrocarbons containing an ether group. In addition, in the condensation reaction as described above, R₁ and R₂ may bond to the same siloxane-based compound or an organometallic compound having a structure similar to the siloxane-based compound, but may bond to other siloxane-based compound or an organometallic compound having a structure similar to the siloxane-based compound, respectively, to form a branched structure or a network structure.

R₁ and R₂ above may bond to various hydrocarbons, in addition to the hydroxyl group or the ether group R₁ and R₂ are derived from a siloxane-based compound used for polymerization or an organometallic compound having a structure similar to the siloxane-based compound, and when one siloxane-based compound or an organometallic compound having a structure similar to the siloxane-based compound is used to form the copolymer, R₁ and R₂ may equally bond thereto in the molecule. However, when two or more kinds of siloxane-based compounds or organometallic compounds having a structure similar to the siloxane-based compounds are used in admixture, different functional groups (R₁ and R₂) may be attached to each point even within the same copolymer molecule. Through this, it is possible to control physical properties such as viscosity, softening point, melting point, hardness and elasticity of the copolymer.

As examples of R₁ and R₂ excluding the hydroxyl group or ether group, it is possible to use a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, or a C1-C8 aromatic hydrocarbon containing an ether group.

Examples of the C1-C20 aliphatic hydrocarbon may include methane, ethane, propane, butane, pentane, hexane, heptane, octane, nonane, decane, a C11-C20 hydrocarbon, an isomer of the C1-C20 aliphatic hydrocarbon, a derivative of the C1-C20 aliphatic hydrocarbon, and the like. In addition, in the case of the C1 to C20 aliphatic hydrocarbon, the main skeleton has a single bond, but a C1 to C20 aliphatic hydrocarbon having 1 to 10 double or triple bonds may be used.

A C3-C20 aromatic hydrocarbon refers to a hydrocarbon having a cyclic structure in which both ends of the C1-C20 aliphatic hydrocarbon are bonded, and an aromatic hydrocarbons having 1 to 10 double or triple bonds in addition to an aromatic hydrocarbon consisting of a single bond may be used, and an aromatic hydrocarbons sharing some double bonds such as benzene may also be used. In addition, the aromatic hydrocarbon may form one cyclic hydrocarbon, but also may be an aromatic hydrocarbon in which two or more rings are bonded, such as naphthalene, or two or more rings are independently present. In addition, the C3-C20 aromatic hydrocarbon may include isomers and derivatives in the same manner as in the aliphatic hydrocarbon.

In addition, in the case of the aromatic hydrocarbon, one or more carbon atoms may be substituted with N, O, S, and F. In the case of the aromatic hydrocarbon, a circular carbon skeleton may be formed, but even when some atoms of these carbons are substituted, the circular molecule as described above may be formed. Thus, in the case of the present invention, a C4-C20 aromatic hydrocarbon containing one or more heteroatoms selected from N, O, S and F may be used.

In addition, the aliphatic hydrocarbon and the aromatic hydrocarbon may be directly bonded to the central atom of the copolymer to form a siloxane or an organometallic compound, or may be bonded using an ether group. That is, when the aliphatic hydrocarbon and the aromatic hydrocarbon have a hydroxyl group, they may be bonded to the siloxane or organometallic compound through condensation polymerization, and in this case, an ether bond may be formed to which an oxygen atom is interposed therebetween. In addition, two or more aliphatic hydrocarbons and the aromatic hydrocarbon hydrogen may form an ether bond, and then the bound molecule may be bound to the siloxane or organometallic compound.

Specific examples of R₁ and R₂ may be -Me, -CH₂Ph, -CH₂NHPh, -n-Pr, -(CH₂)₂(CF₂)nCF₃, -(CH₂)₂-c-C₆H₁₁, -(CH₂)₂Ph, -(CH₂)₂CF₃, - (CH₂)₂C₆F₅, - (CH₂)₂C₆H₄-4-CH₂Cl, - (CH₂)₂C₆H₄-4-Br, - (CH₂)₂OSiMe₂Cl, - (CH₂)₂SiMe₂OMe, - (CH₂)₂SiMe(OMe)₂, - (CH₂)₂Si(OMe), - (CH₂)₃, Ph, - (CH₂)₃,NH₂, - (CH₂)₃NHC(dO) (CH₂)₂CO₂H, -i-Bu, - (CH₂)₃, Cp, - (CH₂)₃, C₆H₄-4-OMe, - (CH₂)₃N[CH₂CH(OH)CH₂OH]₂, - (CH₂)₃, OH, - (CH₂)₃,OCH₂CH(O)CH₂, -(CH₂)₃OC(=O)CBr(CH₂Br)Me, -(CH₂)₃, SH, - (CH₂)₃,Cl, -(CH₂)₃,I, -Cy, -C₆H₄NO₂, -C₆H₄NH, -C₆H₄NHC(=O)CMe₂Br, - C₆H₄SO₃ -C₆H₄PO(OH)OPh, -C₆H₄Br, -OSiMe₂H, -OSiMe, -OSiMe₂(CH₂)₂Ph, -OSiMe₂(CH₂)₂C₆H₄-3-C(CF₃)₂OH, -OSiMe₂(CH₂)₂C₆H₄-4-OH, - OSiMe₂(CH₂)₂C₆H₄-4-CH₂COMe, -OSiMe₂(CH₂)₂C₆H₄-4-OAc, - OSiMe₂(CH₂)₂C₆H₄-4-Cl, -OSiMe₂(CH₂)₂C₆H₄-4-Br, - OSiMe₂(CH₂)₂SiMe(OMe)₂, -OSiMe₂(CH₂)₃C₆H₄-2-OH, -OSiMe₂(CH₂)₃OH, - OSiMe₂(CH₂)₃OC(=O) -C₆H₄-4-NH₂, -OSiMe₂(CH₂)₃OCH₂CH₂OC(dO) -C₆H₄-4-NH₂, -OSiMe₂CH₂CHMe-C₆H₄-4-CMe₂NCO, -OSiMe₂(CH₂)₃OCH₂CH(O)CH₂, - OSiMe₂(CH₂)₃O(CH₂)₂[O(CH₂)₂]nOH, -OSiMe₂(CH₂)₃O(CH₂)₂[O(CH₂)₂]nMe, - OSiMe₂(CH₂)₃OCF₂CHFCF₃, -OSiMe₃-n(OEt)n, -OSiMe₂OSiMe₂H, -OSnMe₃, - (CH₂)₃NH₂, - (CH₂)₃NHCH₂CH(OH)CH₂OPh, - (CH₂)₃N[CH₂CH(OH)CH₂OPh]₂, - (CH₂)₃N[CH₂CH(OH)CH₂OPh] {(CH₂)₂N[CH₂CH(OH)CH₂OPh]₂}, - (CH₂)₃OCH₂CH(O)CH₂, - (CH₂)₃SH, - (CH₂)₃Cl, - (CH₂)₂CHMe₂, - (CH₂)₂CMe₂CO₂Me, - (CH₂)₂(CH₂)₃CF₃, -n-C₆H₁₃, -CH₂CH(Et)(CH₂)₃Me, -n-Oct, - (CH₂)₂(CF₂)₅CF₃, -c-C₅H₉, -Ph, -C₆H₄-2-Me, -C₆H₄-3-Me, -C₆H₄-4-Me, -C₆H₄-4-Cl, -C₆H₄-2-Et, -C₆H₄-2-NHNHPh, or - (i-Oct)₆[(CH₂)3NH₂]. In R₁ and R₂, Me refers to a methyl group, Et refers to an ethyl group, Bu refers to a butyl group, Pr refers to a propyl group, Ph refers to a phenol group, Cy refers to a cyclohexyl group, and Ac refers to an acetyl group, wherein n is an integer between 0 and 7.

In addition, when R₁ or R₂ in the copolymer is an ether group, the copolymer may be a compound of following Formula 4 or 5: 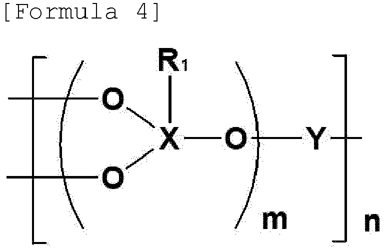
wherein: R₁ is a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, or a hydroxyl group (-OH); X is silicon (Si), titanium (Ti), germanium (Ge), zirconium (Zr), tin (Sn), lead (Pb), bismuth (Bi), antimony (Sb), tellurium (Te), hafnium (Hf), indium (In), or aluminum (Al); Y is a carbonyl group (-COO-), a sulfonyl group (-SO₂-), a phosphoryl group (-PO₃-), or an ether group bonded to a neighboring silanol; m is an integer from 1 to 100; and n is an integer from 1 to 100. 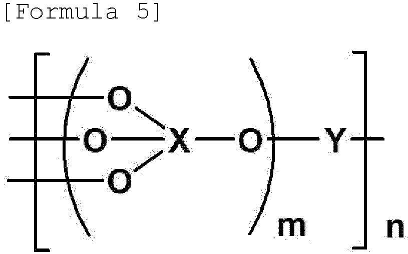
wherein: X is silicon (Si), titanium (Ti), germanium (Ge), zirconium (Zr), tin (Sn), lead (Pb), bismuth (Bi), antimony (Sb), tellurium (Te), hafnium (Hf), indium (In), or aluminum (Al); Y is a carbonyl group (-COO-), a sulfonyl group (-SO₂-), a phosphoryl group (-PO₃-), or an ether group bonded to a neighboring silanol; m is an integer from 1 to 100; and n is an integer from 1 to 100.

When having the structure of Formula 4 or 5, the copolymer may have a linear molecular structure.

The copolymer may be used in admixture with a siloxane compound, in which a central atom is Si, and an organometallic compound, in which a central atom is a metal. That is, the copolymer may include a structure of following Formula 2 and a structure of following Formula 3: 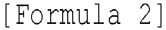 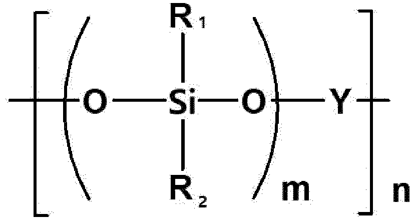
wherein: R₁ and R₂ are each a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, a hydroxyl group (-OH), or an ether group (-O-); Y is a carbonyl group (-COO-), a sulfonyl group (-SO₂-), a phosphoryl group (-PO₃-), or an ether group bonded to a neighboring silanol; m is an integer from 1 to 100; and n is an integer from 1 to 100. 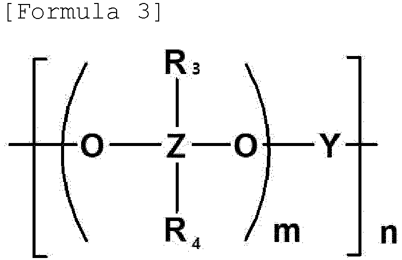
wherein: R₃ and R₄ are each a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, a hydroxyl group (-OH), or an ether group (-O-) ; Z is titanium (Ti), germanium (Ge), zirconium (Zr), tin (Sn), lead (Pb), bismuth (Bi), antimony (Sb), tellurium (Te), hafnium (Hf), indium (In), or aluminum (Al); Y is a carbonyl group (-COO-), a sulfonyl group (-SO₂-), a phosphoryl group (-PO₃-), or an ether group bonded to a neighboring silanol; m is an integer from 1 to 100; and n is an integer from 1 to 100.

In general, the siloxane compound is known to be susceptible to heat, and thus, it is known that it is difficult to use in a high-temperature process. However, in the present invention, it is possible to have high heat resistance while minimizing change in physical properties by using an organometallic compound having high heat resistance in admixture with the siloxane-based compound. In this case, the compound of Formula 2 corresponds to a siloxane-based compound, and the compound of Formula 3 corresponds to an organometallic compound.

The weight ratio of Formula 2 and Formula 3 may be 1:9 to 9.9:0.1, preferably 3:7 to 9.9:0.1, and more preferably 5:5 to 9.9:0.1. The weight ratio of the compound of Formula 2 and the compound of Formula 3 may be determined by the weight ratio of the siloxane-based compound and the organometallic compound to be mixed during the initial synthesis. In this case, if the proportion of the organometallic compound is increased, heat resistance and chemical resistance may be increased, but transparency may be deteriorated, so that it is preferably used in admixture in an appropriate ratio.

The photosensitive composition may further comprise a photosensitizer, a solvent, an adhesion aid, and a surfactant in addition to the polysiloxane copolymer including the organometallic compound.

The photosensitizer is a photopolymerization initiator that photopolymerizes the copolymers by supplied light, and a photosensitizer used in general photosensitive polysiloxane-based compounds may be used. Specifically, the photosensitizer is not particularly limited, but one or more selected from the group consisting of a triazine-based compound, biimidazole compounds, acetophenone-based compounds, O-acyl oxime-based compounds, benzophenone-based compounds, thioxanthone-based compounds, phosphine oxide-based compounds and coumarin-based compounds may be used.

As non-limiting examples of the photosensitizer, it is possible to use triazine-based compounds such as 2,4-trichloromethyl-(4'-methoxyphenyl)-6-triazine, 2,4-trichloromethyl-(4'-methoxystyryl)-6-triazine, 2,4-trichloromethyl-(pyflonyl)-6-triazine, 2,4-trichloromethyl-(3',4'-dimethoxyphenyl)-6-triazine, 3-{4-[2,4-bis(trichloromethyl)-s-triazin-6-yl]phenylthio}propanoic acid, 2,4-trichloromethyl-(4'-ethylbiphenyl)-6-triazine and 2,4-trichloromethyl-(4'-methylbiphenyl)-6-triazine; biimidazole compounds such as 2,2'-bis(2-chlorophenyl)-4,4',5,5'-tetraphenyl biimidazole and 2,2'-bis(2,3-dichlorophenyl)-4,4',5,5'-tetraphenyl biimidazole; acetophenone-based compounds such as 2-hydroxy-2-methyl-1-phenylpropan-1-one, 1-(4-isopropylphenyl)-2-hydroxy-2-methylpropan-1-one, 4-(2-hydroxyethoxy)-phenyl(2-hydroxy)propyl ketone, 1-hydroxycyclohexyl phenyl ketone, 2,2-dimethoxy-2-phenyl acetophenone, 2-methyl-(4-methylthiophenyl)-2-morpholino-1-propan-1-one (Irgacure-907) and 2-benzyl-2-dimethylamino-1-(4-morpholinophenyl)-butan-1-one (Irgacure-369); O-acyloxime-based compounds such as Ciba Geigy's Irgacure OXE 01 and Irgacure OXE 02; benzophenone-based compounds such as 4,4'-bis(dimethylamino)benzophenone and 4,4'-bis(diethylamino)benzophenone; thioxanthone-based compounds such as 2,4-diethyl thioxanthone, 2-chlorothioxanthone, isopropyl thioxanthone, and diisopropyl thioxanthone; phosphine oxide-based compounds such as 2,4,6-trimethylbenzoyl diphenylphosphine oxide, bis(2,6-dimethoxybenzoyl)-2,4,4-trimethylpentyl phosphine oxide, and bis(2,6-dichlorobenzoyl)propyl phosphine oxide; coumarin-based compounds such as 3,3'-carbonylvinyl-7-(diethylamino)coumarin, 3-(2-benzothiazolyl)-7-(diethylamino)coumarin, 3-benzoyl-7-(diethylamino)coumarin, 3-benzoyl-7-methoxy-coumarin, and 10,10'-carbonylbis[1,1,7,7-tetramethyl-2,3,6,7-tetrahydro-1H,5H,11H-Cl]-benzopyrano[6,7,8-ij]-quinolizin-11-one; quinone-based compounds such as 4-naphthoquinone diazide sulfonic acid and 5-naphthoquinone diazide sulfonic acid; and the like, alone or in admixture of two or more.

The photosensitizer may be included in an amount of 1 to 10 parts by weight relative to 100 parts by weight of the copolymer. When the photosensitizer is included in an amount of less than 1 part by weight, photoinitiation may not occur or the sensitivity of the photosensitive composition may be reduced, and when it is included in an amount of more than 10 parts by weight, physical properties of the photosensitive composition may be deteriorated.

The solvent is added to have fluidity by dissolving the photosensitive composition, and may be used without limitation as long as it is a solvent capable of preparing the photosensitive composition solution. Examples of the solvent may be one or more selected from the group consisting of methanol, ethanol, 1-propanol, 2-propanol, 1-butanol, 2-butanol, 2-methyl-1-propanol, acetone, acetonitrile, tetrahydrofuran, toluene, hexane, ethyl acetate, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono tert-butyl ether acetate, and γ-butyrolactone.

The solvent may be used in an amount of 30 to 50 parts by weight relative to 100 parts by weight of the copolymer. When the solvent is mixed in an amount of less than 30 parts by weight, the viscosity of the photosensitive composition increases, so it may be difficult to form a smooth pattern, and when it is mixed in an amount of more than 50 parts by weight, flowability occurs in the photosensitive composition, so a pattern may be formed up to an undesired portion.

In addition, an adhesion aid that assists the copolymer to adhere to the substrate and a surfactant that allows the copolymer to form a uniform pattern may be used in admixture. In this case, 0.1 to 1 part by weight of the adhesive aid and 0.1 to 1 part by weight of the surfactant relative to 100 parts by weight of the copolymer may be used. When they are within the above ranges, the copolymer may smoothly form a pattern, but when they are out of the above ranges, the formation of the pattern may be incomplete or the interface between the pattern and the substrate may be separated.

Hereinafter, the present invention will be described in detail through the method for preparing the photosensitive composition.

The present invention also relates to a method for preparing the photosensitive composition, comprising the steps of: adding and mixing a monomer having a structure of following Formula 7 to a polymerization solvent to produce a monomer mixture: 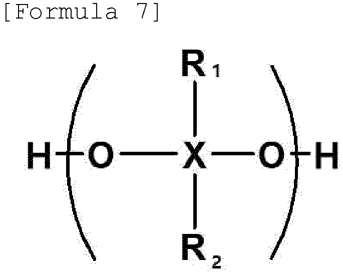
wherein: R₁ and R₂ are each a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, a hydroxyl group (-OH), or an ether group (-O-); and X is silicon (Si), titanium (Ti), germanium (Ge), zirconium (Zr), tin (Sn), lead (Pb), bismuth (Bi), antimony (Sb), tellurium (Te), hafnium (Hf), indium (In), or aluminum (Al);
mixing a copolymerization monomer with the monomer mixture, and then adding an acid catalyst dropwise to produce a copolymer; and mixing 1 to 10 parts by weight of a photosensitizer, 30 to 50 parts by weight of a solvent, 0.1 to 1 parts by weight of an adhesion aid and 0.1 to 1 parts by weight of a surfactant relative to 100 parts by weight of the copolymer to produce the photosensitive composition, wherein the copolymerization monomer is a compound containing a carbonyl group, a sulfonyl group, or a phosphoryl group, and wherein the acid catalyst is one or more selected from oxalic acid, hydrofluoric acid, hydrochloric acid, hydrobromic acid, sulfuric acid, nitric acid, perchloric acid, phosphoric acid, methanesulfonic acid, benzenesulfonic acid, and toluenesulfonic acid.

The monomer is a monomer having the structure of Formula 7, and as described above, when X is silicon (Si), it may be a silane-based monomer, and when X is a metal atom, it may be an organometallic monomer. It is possible to form the copolymer having the structure of Formula 1 of the present invention by copolymerizing the Y compound, which is a non-silane-based monomer in admixture with the compound having the structure of Formula 7.

As an examples of the silane-based monomer, it is possible to use one or more selected from the group consisting of trimethylmethoxysilane, triethylmethoxysilane, trimethylethoxysilane, triethylethoxysilane, trimethylpropoxysilane, triethylpropoxysilane, trimethylbutoxysilane, triethylbutoxysilane, dimethyldimethoxysilane, diethyldimethoxysilane, dimethyldiethoxysilane, diethyldiethoxysilane, methyltrimethoxysilane, ethyltrimethoxysilane, propyltrimethoxysilane, methyltriethoxysilane, ethyltriethoxysilane, propyltriethoxysilane, tetramethoxysilane, tetraethoxysilane, tetrapropoxysilane, tetrabutoxysilane, phenyltrimethoxysilane, diphenyldimethoxysilane, phenyltriethoxysilane, diphenyldiethoxysilane, vinyltrimethoxysilane, vinyltriethoxysilane, 3-acryloxypropyltrimethoxysilane, 3-acryloxypropyltriethoxysilane, 3-trimethoxysilylpropyl methacrylate, 3-triethoxysilylpropyl methacrylate, and vinyl tripropoxysilane.

In addition, as an example of the organometallic monomer, a metal alkoxide-based compound such as titanium methoxide, titanium ethoxide, titanium isopropoxide, titanium butoxide, titanium-tert-butoxide, germanium methoxide, germanium ethoxide, germanium isopropoxide, Germanium butoxide, germanium-tert-butoxide, zirconium methoxide, zirconium ethoxide, zirconium isopropoxide, zirconium butoxide, zirconium-tert-butoxide, tin methoxide, tin ethoxide, tin isopropoxide, tin butoxide, tin-tert-butoxide, lead methoxide, lead ethoxide, lead isopropoxide, lead butoxide and lead-tert-butoxide may be used.

In addition, in the case of the silane-based monomer and the organometallic monomer, a single component may be used, but preferably two or more kinds of monomers may be used in admixture. When a single component monomer is used, certain physical properties (transparency, flowability, adhesiveness, and the like) may be excellent, but it may be difficult to be used as a universally used material for pattern formation. Thus, when two or more, preferably three or more kinds of the monomers are used in admixture, it is preferable to combine them so that they may be used universally while exhibiting high physical properties. In particular, when the silane-based monomer and the organometallic monomer are used in combination in an appropriate ratio as described above, it is possible to form a pattern having high heat resistance and chemical resistance as well as having high transparency.

After the monomer is prepared as described above, it may be mixed with a polymerization solvent. The polymerization solvent may be used without limitation as long as it is a solvent capable of performing polymerization of the monomer, but it is preferable to use the same solvent as the solvent used for preparing the photosensitive composition. Through this, it is possible to minimize the cost required for the separation of the polymerization solvent during the preparation of the photosensitive composition, and also to minimize the deterioration of physical properties due to the residual polymerization solvent.

After mixing of the polymerization solvent and the monomer is completed as described above, the copolymer may be mixed. As seen above, the copolymer monomer may use acetic acid, sulfuric acid or phosphoric acid as a part constituting the non-silane-based monomer, and also may use acetate, sulfate, or phosphate.

As seen above, since the pattern shape of the copolymer may be controlled according to the mixing ratio of the polymerized monomers, the polymerization monomer may be mixed in a proportion of 0.01 to 1 mole relative to 1 mole of the monomer (silane-based monomer or organometallic monomer). When the polymerization monomer is mixed in a proportion of less than 0.01 mol, the effect of changing the pattern shape due to copolymerization of the polymerization monomers may not appear, and when it is mixed in a proportion of more than 1 mol, the taper angle of the generated pattern may be lowered, so that it may be difficult to form a normal pattern.

After mixing of the monomer and the polymerization monomer is completed as described above, an acid catalyst may be added dropwise to carry out the copolymerization reaction. In this case, the acid catalyst may perform the roles of being as a catalyst for the copolymerization reaction and at the same time maintaining the pH during the reaction. In addition, the acid catalyst may be added dropwise over 30 to 120 minutes at a temperature of 70°C or less, preferably 50°C or less, in order to suppress side reactions due to rapid reaction. When it is within the above range, an appropriate copolymerization reaction may be performed, but when it is out of the above range, a side reaction may be performed, thereby deteriorating physical properties.

In addition, in the case of the acid catalyst, the same compound as the polymerization monomer may be used. That is, when phosphoric acid is used as the polymerization monomer, the phosphoric acid may act as an acid catalyst as well as a polymerization monomer, and in this case, it is also possible to simultaneously supply the polymerization monomer and add the acid catalyst dropwise by omitting the process of mixing the polymerization monomer and performing the dropwise addition. It may also be applied equally to the sulfuric acid. However, when the acetic acid is used as a polymerization monomer, or an acetate, sulfate or phosphate is used as a polymerization monomer, since the pH required for the reaction cannot be maintained by the dropwise addition as described above, the copolymerization reaction may be carried out by mixing the polymerization monomers, and then adding an additional acid catalyst dropwise.

After the copolymerization is completed, the photosensitive composition may be prepared by mixing 1 to 10 parts by weight of a photosensitizer, 30 to 50 parts by weight of a solvent, 0.1 to 1 parts by weight of an adhesion aid and 0.1 to 1 parts by weight of a surfactant relative to 100 parts by weight of the copolymer.

In addition, the photosensitive composition of the present invention may be used for positive or negative photosensitization. That is, the photosensitive composition may be used in positive mode and negative mode.

Hereinafter, preferred examples of the present invention will be described so that those of ordinary skill in the art can easily implement them with reference to the accompanying drawings. In addition, in describing the present invention, if it is determined that the specific description of the related known functions or known configurations may unnecessarily obscure the gist of the present invention, the detailed description thereof will be omitted. In addition, certain features presented in the drawings are enlarged, reduced, or simplified for ease of explanation, and the drawings and components are not necessarily drawn to scale. However, those skilled in the art will readily appreciate these details.

### Example 1

An experiment was conducted to confirm the effect of the silane-based compound and the organometallic compound.

The silane-based compound and the organometallic compound were added to a 1 L Jacketed reactor containing 200 mL of propylene glycol monomethyl ether acetate (PGMEA) under a nitrogen atmosphere, as shown in Table 1 below, and mixed.

**[Table 1]**

| Example | PTMS | MTMS | TEOS | ETMS | TPOS | TEOTi | TEOGe | TEOZr | TPOTi | TBOTi |
|---|---|---|---|---|---|---|---|---|---|---|
| 1-1 | 381.3 | - | - | - | - | - | - | - | - | - |
| 1-2 | - | 457.2 | - | - | - | - | - | - | - | - |
| 1-3 | - | - | 375.6 | - | - | - | - | - | - | - |
| 1-4 | 127.1 | 152.4 | 125.2 | - | - | - | - | - | - | - |
| 1-5 | 127.1 | - | 125.2 | 164.8 | - | - | - | - | - | - |
| 1-6 | 127.1 | 152.4 | - | - | 142.8 | - | - | - | - | - |
| 1-7 | 95.3 | 114.3 | 93.9 | - | - | 105.9 | - | - | - | - |
| 1-8 | 95.3 | 114.3 | 93.9 | - | - | - | 116.3 | - | - | - |
| 1-9 | 95.3 | 114.3 | 93.9 | - | - | - | - | 124.8 | - | - |
| 1-10 | 95.3 | 114.3 | 93.9 | - | - | 52.9 | 58.1 | - | - | - |
| 1-11 | 95.3 | 114.3 | 93.9 | - | - | 52.9 | - | 62.4 | - | - |
| 1-12 | 95.3 | 114.3 | 93.9 | - | - | - | - | - | 121.4 | - |
| 1-13 | 95.3 | 114.3 | 93.9 | - | - | - | - | - | - | 138.5 |

In Table 1, each component was added based on weight (g), PTMS refers to phenyltrimethoxysilane, MTMS refers to methyltrimethoxysilane, TEOS refers to tetraethoxysilane, ETMS refers to ethyltrimethoxysilane, TPOS refers to tetrapropoxysilane, TEOTi refers to tetraethoxytitanium, TEOGe refers to tetraethoxygermanium, TEOZr refers to tetraethoxyzirconium, TPOTi refers to tetrapropoxytitanium, and TBOTi refers to tetrabutoxytitanium, respectively.

After the mixed solution was stirred for 10 minutes, 160 g of an 85% aqueous phosphoric acid solution (copolymerization monomer and acid catalyst) dissolved at 0.5% in deionized water was slowly added dropwise over about 1 hour at a reaction temperature of 50°C or less and reacted. Thereafter, the reaction solution was stirred for 10 minutes, heated to 80°C, and then stirred for 8 hours to polymerize a siloxane-based copolymer.

### Experimental Example 1

The weight average molecular weight and ADR (2.38% tetramethylammonium hydroxide (TMAH) developer) of the copolymer synthesized in the ratio in Example 1 above were measured, respectively.

**[Table 2]**

| Example | weight average molecular weight | ADR(Å) |
|---|---|---|
| 1-1 | 3,678 | 1,248 |
| 1-2 | 3,957 | 1,259 |
| 1-3 | 3,554 | 1,295 |
| 1-4 | 3,827 | 1,309 |
| 1-5 | 3,647 | 1,228 |
| 1-6 | 3,558 | 1,195 |
| 1-7 | 3,651 | 1,198 |
| 1-8 | 3,786 | 1,120 |
| 1-9 | 3,916 | 1,045 |
| 1-10 | 3,702 | 1,146 |
| 1-11 | 3,804 | 1,101 |
| 1-12 | 3,758 | 1,195 |
| 1-13 | 3,696 | 1,155 |

As shown in Table 2 above, it could be confirmed that Examples 1-1 to 1-13 of the present invention form the copolymer, and it was also shown that they have the physical properties similar to Example 1-1 formed of siloxane, and thus may be used in the photosensitive composition.

In addition, an experiment was conducted to confirm the structure and components of Example 1-4. ¹H-NMR and FT-IR analysis were performed using the compound prepared in Example 4.

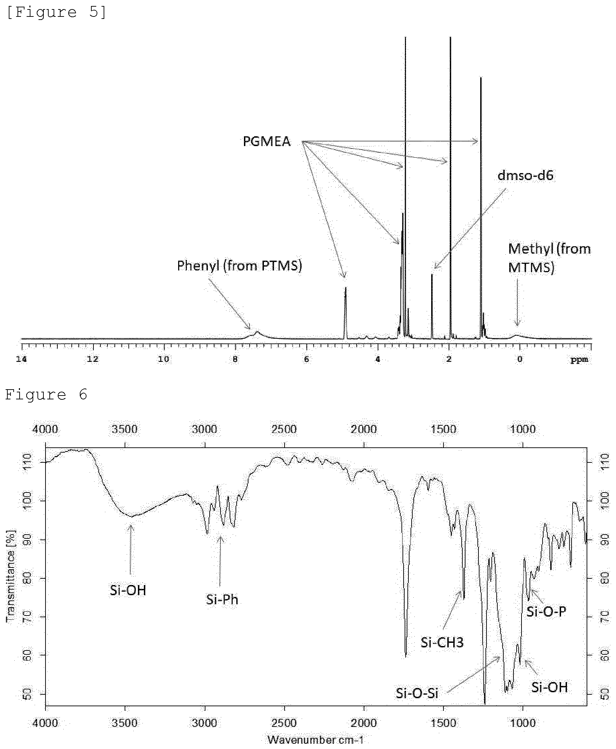

As shown in Figure 5, as a result of ¹H-NMR analysis, a phenyl group and a methyl group of PTMS and MTMS used in the present invention were observed. However, it could be confirmed that since TEOS does not generate hydrogen (H) during hydrolysis, it does not appear in the NMR analysis results, and since the invention is prepared by mixing with a solvent, the peak of PGMEA used as a solvent appears to be large.

In the case of the FT-IR analysis result, the peaks of each functional group bonded to Si, which is the central atom, could be confirmed as shown in Figure 6, and thus, it could be confirmed that the present invention has the structure of Formula 1 (other peaks between 1000-2000 cm⁻¹ are peaks by PGMEA) .

### Example 2

5.5 g of the polysiloxane copolymer (binder resin) prepared in Example 1, 1.65 g of SR399 (sartomer) (crosslinkable compound), 0.5 g of TPM-P07 (Tacoma Technology Co., Ltd.) (photopolymerization initiator), 7.5 g of propylene glycol monomethyl ether acetate (PGMEA) (organic solvent), 0.03 g of KBM403 (Shin-Etsu Co., Ltd.) (adhesive aid), and 0.08 g of FZ-2122 (DOW Chemical Company) (surfactant) were put into the reactor and stirred at room temperature for 3 hours, and then subject to the process of filtration through a 5.0 um filter to prepared a photosensitive resin composition (solids content of 25%) .

### Experimental Example 2

Each of the sensitivity (mJ/cm²), retention rate after development (%), retention rate after postbake (PB) (%), heat resistance (°C), and transmittance (%) was tested for the photosensitive resin composition prepared in Example 2 above. Each of the experimental methods is as follows:

### (1) Sensitivity

After the photosensitive resin composition was applied on a glass substrate by spin coating, heat treatment (hot plate) was performed at 110°C for 90 seconds to form a thin film having a thickness of 2 um. The thickness of the formed thin film was measured with a stylus profilometer (Veeco Instruments Inc.; DEKTAK 150). Thereafter, the thin film was exposed to a high-pressure mercury lamp through a mask, and then spray-developed with 2.38% TMAH developer to obtain a pattern.

### (2) Retention rate after development

After the photosensitive resin composition was applied on a glass substrate by spin coating, heat treatment (hot plate) was performed at 110°C for 90 seconds to form a thin film having a thickness of 2 um. Then, after the photolithography process was performed, the thickness change before and after development was measured using a stylus profilometer (DEKTAK 6M; Veeco Instruments Inc., USA) to determine the retention after development.

### (3) Retention rate after postbake (PB)

After the photosensitive resin composition was applied on a glass substrate by spin coating, heat treatment (hot plate) was performed at 110°C for 90 seconds to form a thin film having a thickness of 2 um. Then, after the photolithography process was performed, change in the thickness after development and the thickness after postbake at 250°C/60 min was measured using a stylus profilometer (DEKTAK 6M; Veeco Instruments Inc., USA) to determine the retention rate.

### (4) Heat resistance

After the photosensitive resin composition was applied on a glass substrate by spin coating, heat treatment (hot plate) was performed at 110°C for 90 seconds to form a thin film having a thickness of 2 um. Thereafter, a cured film was obtained through postbake at 250°C/60 min, and a 5% decomposition temperature of the obtained cured film was measured through TGA analysis equipment.

### (5) Transmittance

After the photosensitive resin composition was applied on a glass substrate by spin coating, heat treatment (hot plate) was performed at 110°C for 90 seconds to form a thin film having a thickness of 2 um. Thereafter, a cured film was obtained through postbake at 250°C/60 min, and the average transmittance of the obtained cured film with respect to light having a wavelength of 400 to 800 nm was measured using a UV-spectrometer.

The results of each experiment are shown in Table 3 below.

**[Table 3]**

| Example | Sensitivi ty | Retention rate after development | Retention rate after PB | Heat resistance | Transmittanc e |
|---|---|---|---|---|---|
| 2-1 | 80 | 85 | 90 | 355 | 97 |
| 2-2 | 80 | 84 | 91 | 350 | 97 |
| 2-3 | 80 | 86 | 94 | 350 | 97 |
| 2-4 | 80 | 85 | 88 | 372 | 97 |
| 2-5 | 85 | 87 | 87 | 369 | 97 |
| 2-6 | 85 | 88 | 88 | 360 | 97 |
| 2-7 | 85 | 87 | 86 | 381 | 91 |
| 2-8 | 85 | 87 | 88 | 384 | 93 |
| 2-9 | 90 | 90 | 89 | 379 | 92 |
| 2-10 | 85 | 88 | 90 | 383 | 92 |
| 2-11 | 85 | 87 | 89 | 384 | 94 |
| 2-12 | 85 | 88 | 90 | 384 | 92 |
| 2-13 | 85 | 88 | 88 | 385 | 92 |

As shown in Table 3, it was confirmed that Examples 2-1 to 2-6 of the present invention have high physical properties and thus may be used as a photosensitive composition. In addition, it could be confirmed that Examples 2-7 to 2-13 using the organometallic compound showed slightly reduced transmittance, but improved heat resistance.

### Example 3

20 g of the polysiloxane copolymer (binder resin) prepared in Example 1, 1 g of diazonaphthoquinone compound (photosensitizer), 8 g of propylene glycol monomethyl ether acetate (PGMEA) (organic solvent), 0.1 g of KBM403 (Shin-Etsu Co., Ltd.) (adhesive aid), and 0.14 g of FZ-2122 (DOW Chemical Company) (surfactant) were put into the reactor and stirred at room temperature for 3 hours, and then subject to the process of filtration through a 5.0 um filter to prepared a photosensitive resin composition (solids content of 25%).

### Experimental Example 3

Each of the sensitivity (mJ/cm²), retention rate after development (%), retention rate after postbake (PB) (%), heat resistance (°C), and transmittance (%) was tested for the photosensitive resin composition prepared in Example 2 above. Each of the experimental methods was carried out in the same manner as in Experimental Example 2, and the results are shown in Table 4 below.

**[Table 4]**

| Example | Sensitivi ty | Retention rate after development | Retention rate after PB | Heat resistance | Transmittanc e |
|---|---|---|---|---|---|
| 3-1 | 30 | 85 | 81 | 415 | 98 |
| 3-2 | 30 | 84 | 79 | 376 | 99 |
| 3-3 | 30 | 89 | 74 | 355 | 97 |
| 3-4 | 20 | 94 | 86 | 428 | 98 |
| 3-5 | 20 | 94 | 86 | 415 | 98 |
| 3-6 | 20 | 93 | 87 | 421 | 97 |
| 3-7 | 30 | 94 | 89 | 498 | 91 |
| 3-8 | 20 | 95 | 85 | 494 | 93 |
| 3-9 | 20 | 94 | 84 | 485 | 92 |
| 3-10 | 30 | 93 | 89 | 488 | 92 |
| 3-11 | 30 | 92 | 86 | 489 | 94 |
| 3-12 | 20 | 92 | 88 | 495 | 92 |
| 3-13 | 20 | 93 | 87 | 493 | 92 |

As shown in Table 4, it was confirmed that Examples 3-1 to 3-6 of the present invention have high physical properties and thus may be used as a photosensitive composition. In addition, it could be confirmed that Examples 3-7 to 3-13 using the organometallic compound showed slightly reduced transmittance, but improved heat resistance.

### Example 4

In order to confirm the effect according to the change of the copolymerization monomer and the acid catalyst during the preparation of Example 1 above, a copolymer was prepared in the same manner using the monomer of Example 1-4, but prepared by changing the kind and content of the copolymerization monomer and the acid catalyst. In this case, the ratio of the copolymerization monomer and the acid catalyst used is shown in Table 5 below.

**[Table 5]**

| Example | | Phosphoric acid (g) | Sulfuric acid (g) | Acetic acid (g) | Hydrochloric acid (g) |
|---|---|---|---|---|---|
| 4-1 | Copolymerizati on monomer | 60 | - | - | - |
| | Acid catalyst | 100 | - | - | - |
| 4-2 | Copolymerizati on monomer | - | 60 | - | - |
| | Acid catalyst | - | 100 | - | - |
| 4-3 | Copolymerizati on monomer | - | - | 60 | - |
| | Acid catalyst | - | - | 100 | - |
| 4-4 | Copolymerizati on monomer | - | - | 60 | - |
| | Acid catalyst | - | - | - | 100 |
| 4-5 | Copolymerizati on monomer | 60 | - | - | - |
| | Acid catalyst | - | - | - | 100 |
| 4-6 | Copolymerizati on monomer | 60 | - | - | - |
| | Acid catalyst | 50 | - | - | - |
| 4-7 | Copolymerizati on monomer | 10 | - | - | - |
| | Acid catalyst | 100 | - | - | - |
| 4-8 | Copolymerizati on monomer | 100 | - | - | - |
| | Acid catalyst | 100 | - | - | - |

### Example 5

5.5 g of the polysiloxane copolymer (binder resin) prepared in Example 4 above, 1.65 g of SR399 (sartomer) (crosslinkable compound), 0.5 g of TPM-P07 (Tacoma Technology Co., Ltd.) (photopolymerization initiator), 7.5 g of propylene glycol monomethyl ether acetate (PGMEA) (organic solvent), 0.03 g of KBM403 (Shin-Etsu Co., Ltd.) (adhesive aid), and 0.08 g of FZ-2122 (DOW Chemical Company) (surfactant) were put into the reactor and stirred at room temperature for 3 hours, and then subject to the process of filtration through a 5.0 um filter to prepared a photosensitive resin composition (solids content of 25%) .

### Experimental Example 4

Each of the sensitivity (mJ/cm²), retention rate after development (%), retention rate after postbake (PB) (%), heat resistance (°C), and transmittance (%) was tested using the copolymer in Example 5 above, and the taper angle (°) was measured by forming a pattern on the substrate in the following way, and then observing it.

### (6) Taper angle measurement

After the photosensitive resin composition was applied on a glass substrate by spin coating, heat treatment (hot plate) was performed at 90 to 110°C for 90 seconds to form a thin film having a thickness of 2 um. Thereafter, the thin film was exposed to a high-pressure mercury lamp through a mask, and then spray-developed with 2.38% TMAH developer to obtain a pattern. Thereafter, the taper angle of the pattern obtained through postbake at 250°C/60 min was measured through FE-SEM.

The results of each experiment are shown in Table 6 below.

**[Table 6]**

| Example | Sensiti vity | Retention rate after development | Retention rate after PB | Heat resistance | Transmit tance | Taper angle |
|---|---|---|---|---|---|---|
| 5-1 | 80 | 84 | 89 | 371 | 97 | 66 |
| 5-2 | 80 | 84 | 90 | 380 | 97 | 67 |
| 5-3 | - | - | - | - | - | - |
| 5-4 | 75 | 80 | 87 | 390 | 97 | 66 |
| 5-5 | 80 | 84 | 89 | 388 | 97 | 67 |
| 5-6 | 80 | 85 | 90 | 382 | 97 | 65 |
| 5-7 | 80 | 85 | 91 | 368 | 97 | 66 |
| 5-8 | 50 | 70 | 90 | 365 | 97 | 67 |

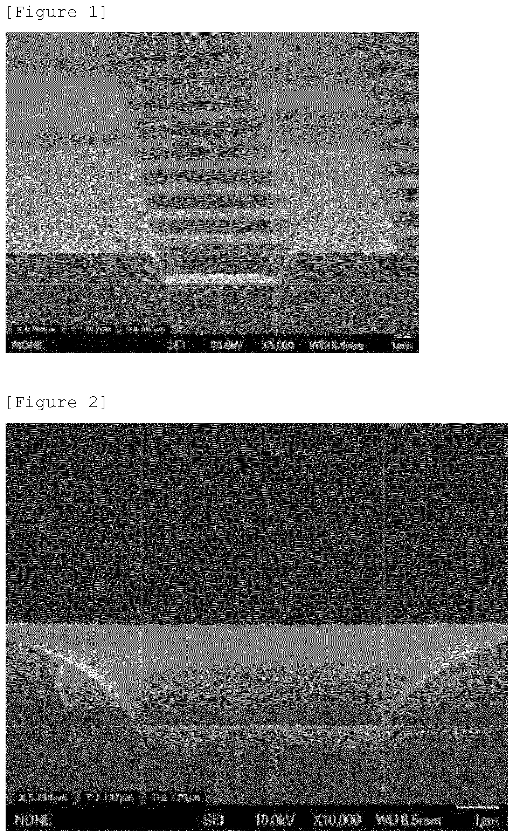

As shown in Table 6 and Figure 1, Examples 5-1 and 5-2 of the present invention were found to have appropriate physical properties and taper angle. However, it was confirmed that Example 5-3 using acetic acid, which is a weak acid, as an acid catalyst was not polymerized because it was difficult to maintain the pH with the acid catalyst, and Example 5-4 changing the acid catalyst to hydrochloric acid was synthesized normally. In addition, it was confirmed that Example 5-5 using phosphoric acid as a copolymerization monomer and using hydrochloric acid as an acid catalyst performed copolymerization (Figure 2).

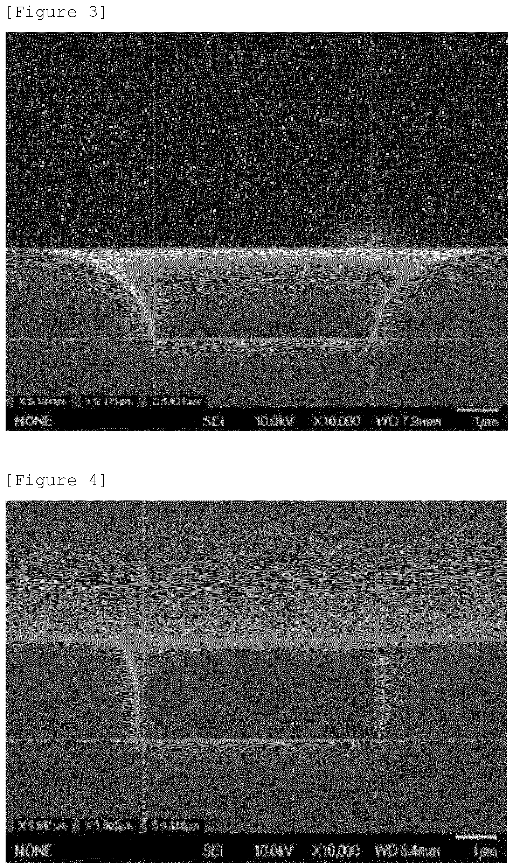

In addition, it was confirmed that Example 5-6 suppressing the use of the acid catalyst shows the sharpened taper angle due to the decrease in phosphoric acid added as a copolymerization monomer during the reaction, and also shows the reduced physical properties (Figure 3).

It was confirmed that Example 5-7 using a small amount of copolymerization monomer shows the increased taper angle as shown in Table 5 above (Figure 4), and it could be confirmed that Example 5-8 using an excess of copolymerization monomer shows the reduced taper angle. Thus, the taper angle of the pattern may be controlled by adjusting the mixing ratio of the copolymerization monomers.

### Example 6

20 g of the polysiloxane copolymer (binder resin) prepared in Example 4 above, 1 g of diazonaphthoquinone compound (photosensitizer), 8 g of propylene glycol monomethyl ether acetate (PGMEA) (organic solvent), 0.1 g of KBM403 (Shin-Etsu Co., Ltd.) (adhesive aid), and 0.14 g of FZ-2122 (DOW Chemical Company) (surfactant) were put into the reactor and stirred at room temperature for 3 hours, and then subject to the process of filtration through a 5.0 um filter to prepared a photosensitive resin composition (solids content of 25%).

### Experimental Example 5

Each of the sensitivity (mJ/cm²), retention rate after development (%), retention rate after postbake (PB) (%), heat resistance (°C), transmittance (%), and taper angle (°) was tested in the same manner as in Experimental Example 4 using the copolymer in Example 6 above. The results of each experiment are shown in Table 7 below.

**[Table 7]**

| Example | Sensiti vity | Retention rate after development | Retention rate after PB | Heat resistance | Transmit tance | Taper angle |
|---|---|---|---|---|---|---|
| 6-1 | 20 | 93 | 84 | 412 | 99 | 39.4 |
| 6-2 | 30 | 92 | 86 | 417 | 98 | 38.4 |
| 6-3 | - | - | - | - | - | - |
| 6-4 | 20 | 94 | 87 | 418 | 97 | 42.8 |
| 6-5 | 20 | 93 | 85 | 419 | 98 | 56.3 |
| 6-6 | 30 | 84 | 71 | 324 | 91 | 68.4 |
| 6-7 | 30 | 95 | 88 | 415 | 98 | 80.5 |
| 6-8 | 20 | 94 | 84 | 417 | 97 | 18 |

It could be confirmed that almost the same results as in Example 5 above were obtained and the taper angle was also controllable.

### Comparative Example 1

A photosensitive resin composition was prepared in the same manner as in Examples, except that an acrylic resin (weight average molecular weight of 13,000) obtained by polymerizing 30% by weight of benzyl methacrylate, 10% by weight of methyl methacrylate and 10% by weight of methacrylic acid to a solid content of 30% in the presence of propylene glycol monomethyl ether acetate (PGMEA) was used instead of the polysiloxane copolymer in Example 1 as a binder resin.

### Comparative Example 2

5.5 g of the acrylic resin used in Comparative Example 1, 1 g of diazonaphthoquinone compound (photosensitizer), 8 g of propylene glycol monomethyl ether acetate (PGMEA), 0.1 g of KBM403 (adhesive aid), and 0.14 g of FZ-2122 (surfactant) were put into the reactor and stirred at room temperature for 3 hours, and then subject to the process of filtration through a 5.0 um filter to prepared a photosensitive resin composition (solids content of 25%).

### Comparative Experimental Example 1

Each of the sensitivity (mJ/cm²), retention rate after development (%), retention rate after postbake (PB) (%), heat resistance (°C), transmittance (%), and taper angle was measured using the photosensitive resin compositions prepared in Comparative Examples 1 and 2 above, and the results are shown in Table 8 below.

**[Table 8]**

| Comparat ive Example | Sensiti vity | Retention rate after development | Retention rate after PB | Heat resistance | Transmit tance | Taper angle |
|---|---|---|---|---|---|---|
| 1 | 120 | 80 | 85 | 230 | 97 | 25 |
| 2 | 100 | 80 | 85 | 230 | 97 | 16 |

As shown in Table 8, in the case of the Comparative Examples using the same resin as in the existing method, it could be confirmed that the sensitivity was lowered and the taper angle was also small. In addition, it could be confirmed that they have a lower temperature compared with the Examples of the present invention in terms of heat resistance, and thus, the Examples of the present invention show high heat resistance.

As a specific part of the present invention has been described in detail above, it will be apparent to those skilled in the art that these specific descriptions are only preferred embodiments, and the scope of the present invention is not limited thereby. Accordingly, it is intended that the substantial scope of the present invention be defined by the appended claims and equivalents thereof.

## Claims

1. A photosensitive composition comprising a copolymer having a structure of following Formula 1: 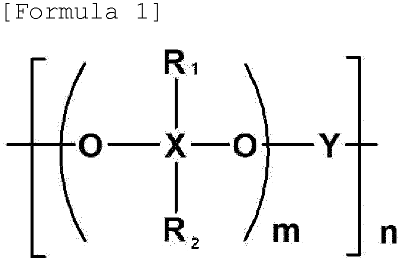 wherein:
R₁ and R₂ are each a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, a hydroxyl group (-OH), or an ether group (-O-);
X is silicon (Si), titanium (Ti), germanium (Ge), zirconium (Zr), tin (Sn), lead (Pb), bismuth (Bi), antimony (Sb), tellurium (Te), hafnium (Hf), indium (In), or aluminum (Al);
Y is a carbonyl group (-COO-), a sulfonyl group (-SO₂-), a phosphoryl group (-PO₃-), or an ether group bonded to a neighboring silanol;
m is an integer from 1 to 100; and
n is an integer from 1 to 100.

2. The photosensitive composition according to claim 1, **characterized in that** the copolymer includes a structure of following Formula 2 and a structure of following Formula 3: 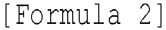 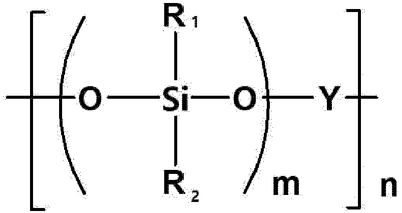 wherein:
R₁ and R₂ are each a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, a hydroxyl group (-OH), or an ether group (-O-);
Y is a carbonyl group (-COO-), a sulfonyl group (-SO₂-), a phosphoryl group (-PO₃-), or an ether group bonded to a neighboring silanol;
m is an integer from 1 to 100; and
n is an integer from 1 to 100. 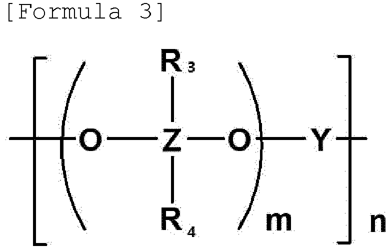 wherein:
R₃ and R₄ are each a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, a hydroxyl group (-OH), or an ether group (-O-);
Z is titanium (Ti), germanium (Ge), zirconium (Zr), tin (Sn), lead (Pb), bismuth (Bi), antimony (Sb), tellurium (Te), hafnium (Hf), indium (In), or aluminum (Al);
Y is a carbonyl group (-COO-), a sulfonyl group (-SO₂-), a phosphoryl group (-PO₃-), or an ether group bonded to a neighboring silanol;
m is an integer from 1 to 100; and
n is an integer from 1 to 100.

3. The photosensitive composition according to claim 1, **characterized in that** the copolymer includes a structure of following Formula 4 or 5: 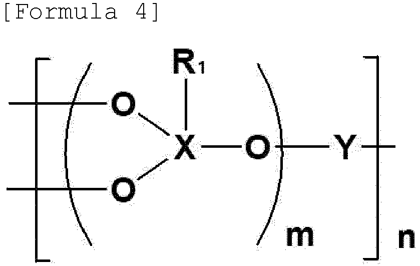 wherein:
R₁ is a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, or a hydroxyl group (-OH) ;
X is silicon (Si), titanium (Ti), germanium (Ge), zirconium (Zr), tin (Sn), lead (Pb), bismuth (Bi), antimony (Sb), tellurium (Te), hafnium (Hf), indium (In), or aluminum (Al);
Y is a carbonyl group (-COO-), a sulfonyl group (-SO₂-), a phosphoryl group (-PO₃-), or an ether group bonded to a neighboring silanol;
m is an integer from 1 to 100; and
n is an integer from 1 to 100. 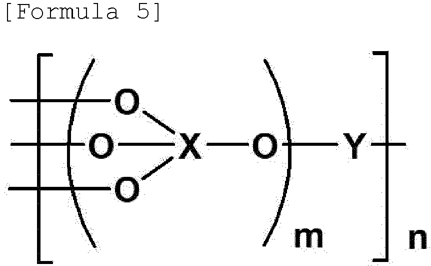 wherein:
X is silicon (Si), titanium (Ti), germanium (Ge), zirconium (Zr), tin (Sn), lead (Pb), bismuth (Bi), antimony (Sb), tellurium (Te), hafnium (Hf), indium (In), or aluminum (Al);
Y is a carbonyl group (-COO-), a sulfonyl group (-SO₂-), a phosphoryl group (-PO₃-), or an ether group bonded to a neighboring silanol;
m is an integer from 1 to 100; and
n is an integer from 1 to 100.

4. The photosensitive composition according to claim 1, **characterized in that** the copolymer includes a structure of following Formula 6: 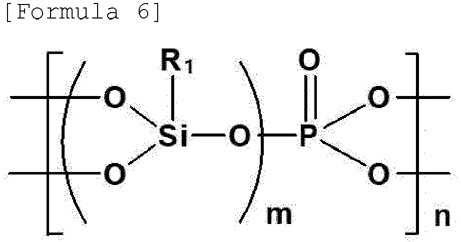 wherein:
R₁ is a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, a hydroxyl group (-OH), or an ether group (-O-);
m is an integer from 1 to 100; and
n is an integer from 1 to 100.

5. The photosensitive composition according to claim 2, wherein the weight ratio of Formula 2 and Formula 3 is 1:9 to 9.9:0.1.

6. The photosensitive composition according to claim 1, wherein the photosensitive composition further comprises 1 to 10 parts by weight of a photosensitizer, 30 to 50 parts by weight of a solvent, 0.1 to 1 parts by weight of an adhesion aid, and 0.1 to 1 parts by weight of a surfactant relative to 100 parts by weight of the copolymer.

7. A method for preparing the photosensitive composition according to any one of claims 1 to 6, wherein the method comprises the steps of: adding and mixing a monomer having a structure of following Formula 7 to a polymerization solvent to produce a monomer mixture: 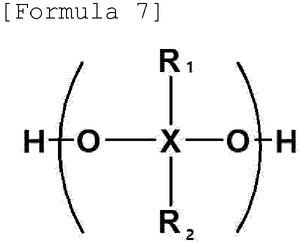 wherein:
R₁ and R₂ are each a C1-C20 aliphatic hydrocarbon, a C3-C20 aromatic hydrocarbon, a C4-C20 aromatic hydrocarbon containing one or more heteroatoms selected from N, O, S and F, a C1-C8 aliphatic hydrocarbon containing an ether group, a C1-C8 aromatic hydrocarbon containing an ether group, a hydroxyl group (-OH), or an ether group (-O-); and
X is silicon (Si), titanium (Ti), germanium (Ge), zirconium (Zr), tin (Sn), lead (Pb), bismuth (Bi), antimony (Sb), tellurium (Te), hafnium (Hf), indium (In), or aluminum (Al);
mixing a copolymerization monomer with the monomer mixture, and then adding an acid catalyst dropwise to produce a copolymer; and
mixing 1 to 10 parts by weight of a photosensitizer, 30 to 50 parts by weight of a solvent, 0.1 to 1 parts by weight of an adhesion aid and 0.1 to 1 parts by weight of a surfactant relative to 100 parts by weight of the copolymer to produce the photosensitive composition,
wherein the copolymerization monomer is a compound containing a carbonyl group, a sulfonyl group, or a phosphoryl group, and
wherein the acid catalyst is one or more selected from oxalic acid, hydrofluoric acid, hydrochloric acid, hydrobromic acid, sulfuric acid, nitric acid, perchloric acid, phosphoric acid, methanesulfonic acid, benzenesulfonic acid, and toluenesulfonic acid.

8. The method for preparing the photosensitive composition according to 7, wherein the monomer having the structure of Formula 7 is in admixture of two or more kinds of monomers.
